# EUROPEAN PATENT APPLICATION

(11) **EP 4 468 334 A1**
(43) Date of publication of application: **27.11.2024**
(21) Application number: 24175386.2
(22) Date of filing: 13.05.2024
(51) Int. Cl.: H01L 23/16, H01L 23/495, H01L 23/00, H01L 23/29, H01L 23/31, H01L 23/62

(54) **A STRUCTURE TO REDUCE CHIP SHIFT DURING ASSEMBLY**

(30) Priority: 26.05.2023 CN 202310612147
(71) Applicant: Littelfuse Semiconductor (Wuxi) Co., Ltd., Wuxi, Jiangsu 214142 (CN)
(72) Inventor: WANG, MC, Wuxi, 214142 (CN); SANG, Ying, Wuxi, 214142 (CN); WANG, Luna, Wuxi, 214142 (CN)
(74) Representative: Arnold & Siedsma

(57) **Abstract**

A semiconductor device, apparatus, structure, and associated methods thereof. The device includes a semiconductor chip, a ring structure configured to retain a lattice having a plurality of cells, the ring structure and the lattice being coupled to the semiconductor chip, one or more semiconductor device connection components being coupled to the semiconductor chip using one or more binding components disposed within the ring structure and the lattice, and a housing configured to encapsulate the semiconductor chip, the ring structure and the lattice, and the one or more semiconductor device connection components.

## Description

### TECHNICAL FIELD

This disclosure relates generally to the field of power semiconductor devices, and in particular, to structures for reducing shifting of chips during semiconductor package assemblies.

### BACKGROUND

Packaging an integrated circuit is typically a final stage of a semiconductor device fabrication process. During packaging, a semiconductor die, which represents the core of a semiconductor device, is encased in a housing that protects the die against physical damage and corrosion. For example, semiconductor dies are commonly mounted on a copper substrate, using solder alloy reflow, conductive epoxy, etc. The mounted semiconductor die is often then encapsulated within a plastic or epoxy compound. However, during manufacture of the semiconductor devices, damage to semiconductor chips is frequently sustained through connection component dislocations, silicon pealing from the semiconductor chips, resulting in inoperable and/or poor quality semiconductor chips.

### SUMMARY

In some implementations, the current subject matter relates to a semiconductor device having semiconductor chip shift reducing structures. The device may include a semiconductor chip, a ring structure configured to retain a lattice having a plurality of cells, the ring structure and the lattice being coupled to the semiconductor chip, one or more semiconductor device connection components being coupled to the semiconductor chip using one or more binding components disposed within the ring structure and the lattice, and preferably a housing configured to encapsulate the semiconductor chip, the ring structure and the lattice, and one or more semiconductor device connection components.

In some implementations, the current subject matter may include one or more of the following optional features. In some implementations, the ring structure and the lattice are configured to be coupled to a bottom side of the semiconductor chip. Another semiconductor chip may be coupled to the bottom side of the semiconductor chip. The ring structure and the lattice may be configured to be disposed between the semiconductor chip and the another semiconductor chip, thereby preventing shifting of at least one of the semiconductor chip and the another semiconductor chip. Another semiconductor chip may be coupled to another ring structure configured to retain another lattice having a plurality of another cells.

In some implementations, each cell in the plurality of cells may have at least one of: a predetermined size, a predetermined shape, a predetermined height, and any combination thereof. All cells in the plurality of cells may have same at least one of: size, shape, height, and any combination thereof. Alternatively, or in addition, at least one cell in the plurality of cells may have a different size, shape, and/or height than at least another cell in the plurality of cells.

In some implementations, the ring structure may be configured to be coupled to the lattice. The plurality of cells may be configured to be evenly distributed within the ring structure. Alternatively, or in addition, the plurality of cells may be configured to be randomly distributed within the ring structure. Further, One or more binding components may be configured to be retained by one or more cells in the plurality of cells. The ring structure may be configured to prevent spilling of the one or more binding components outside of the ring structure and the lattice. One or more binding components may include solder.

In some implementations, one or more semiconductor device connection components may include a lead frame configured to be coupled to a bottom side of the semiconductor chip using the one or more binding components. The ring structure and the lattice may be configured to be positioned between the lead frame and the semiconductor chip. One or more semiconductor device connection components may include a clip fully encapsulated by the housing, wherein another lead frame is configured to be coupled to the clip. The clip may be configured to be coupled to the semiconductor chip. The lead frame may include a lead frame terminal end and the another lead frame includes another lead frame terminal end. The lead frame terminal end and the another lead terminal frame end are configured to be coupled to at least one of the following: a substrate, a printed circuit board, and any combination thereof.

In some implementations, the housing may be manufactured from at least one of the following: an epoxy compound, a plastic, and any combination thereof.

In some implementations, the semiconductor device may be a transient voltage suppression device.

In some implementations, the current subject matter relates to a semiconductor device. The device may include a semiconductor chip, a ring structure configured to retain a lattice having a plurality of cells, the ring structure and the lattice being coupled to the semiconductor chip, one or more semiconductor device connection components being coupled to the semiconductor chip using one or more binding components disposed within the ring structure and the lattice, another semiconductor chip coupled to a bottom side of the semiconductor chip, wherein the ring structure and the lattice are configured to be disposed between the semiconductor chip and the another semiconductor chip, thereby preventing shifting of at least one of the semiconductor chip and the another semiconductor chip, and a housing configured to encapsulate the semiconductor chip, the another semiconductor chip, the ring structure and the lattice, and the one or more semiconductor device connection components.

In some implementations, the current subject matter relates to a method of manufacturing a semiconductor device. The method may include providing a semiconductor chip, forming a ring structure configured to retain a lattice having a plurality of cells, coupling the ring structure and the lattice to the semiconductor chip, coupling one or more semiconductor device connection components to the semiconductor chip using one or more binding components disposed within the ring structure and the lattice, and forming a housing configured to encapsulate the semiconductor chip, the ring structure and the lattice, and the one or more semiconductor device connection components.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIG. 1 illustrates an exemplary semiconductor device structure, according to some implementations of the current subject matter;
FIG. 2 illustrates a top view of the mask, according to some implementations of the current subject matter;
FIG. 3 illustrates an exemplary ring structure, according to some implementations of the current subject matter;
FIG. 4 illustrates the ring structure and the mask shown in FIG. 3, according to some implementations of the current subject matter;
FIG. 5 illustrates a side view of a chip;
FIG. 6 illustrates a top view of the chip shown in FIG. 5;
FIG. 7 illustrates a bottom view of the chip shown in FIG. 5; and
FIG. 8 illustrates an exemplary process, according to some implementations of the current subject matter.

The drawings are not necessarily to scale. The drawings are merely representations, not intended to portray specific parameters of the disclosure. The drawings are intended to depict exemplary implementations of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide a structure for power semiconductor devices that may be configured to prevent shifting of semiconductor chips during assembly.

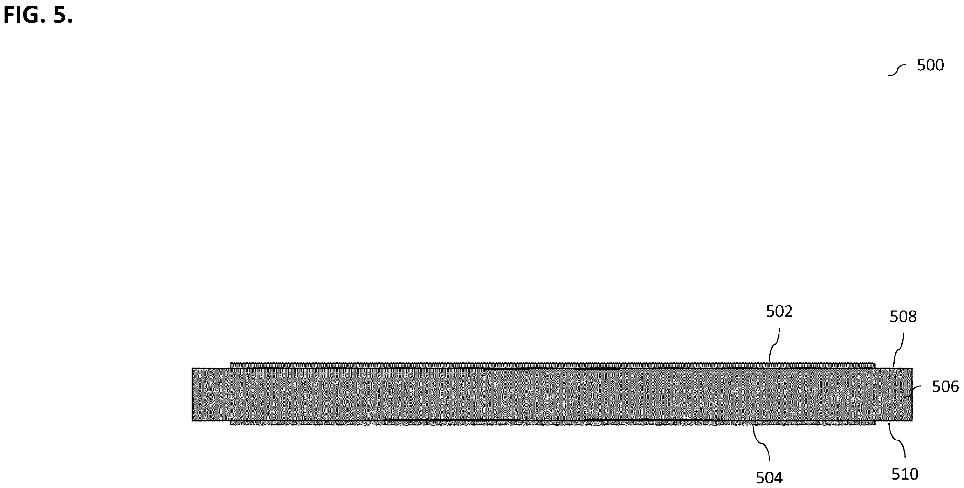

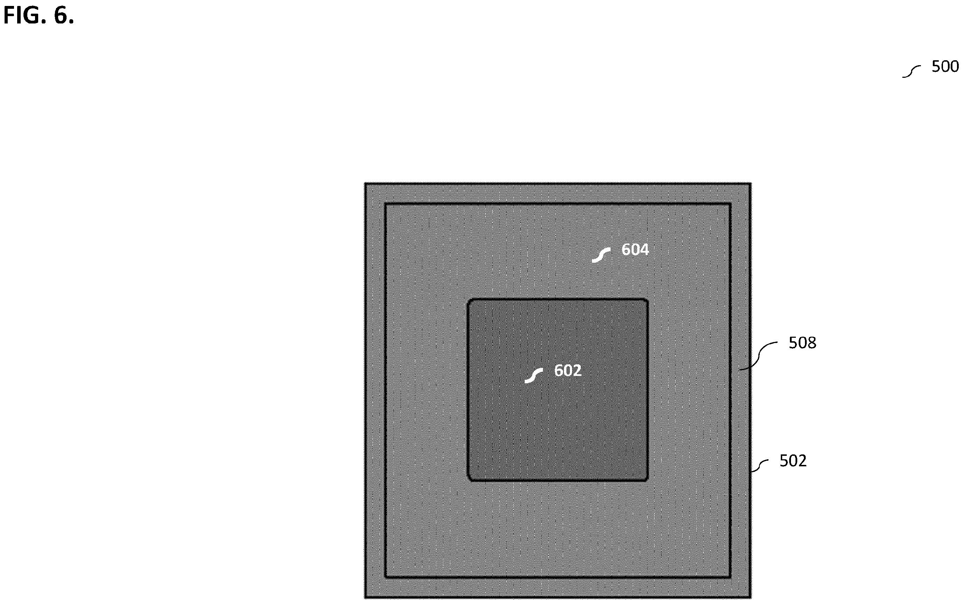

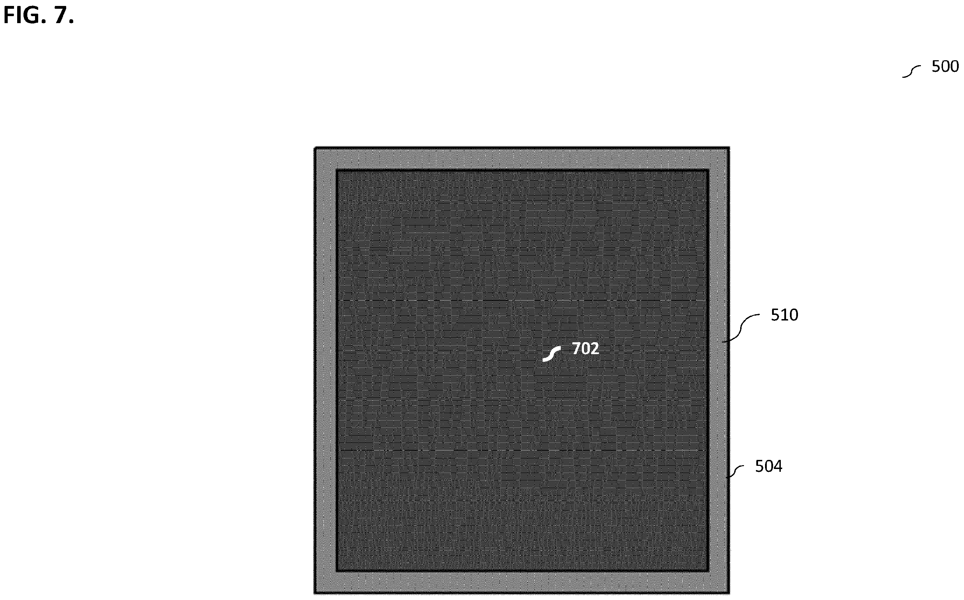

The current subject matter may be configured to be used in connection with any type of semiconductor devices, such as, for example, transient voltage suppressor (TVS) semiconductor devices, thyristors, and/or any other types of devices. The semiconductor devices, such as, TVS devices, may be used to protect electronic components from transient voltages, overvoltage, etc. A TVS chip typically serves as a core part for a TVS semiconductor device. One or more chips may be stacked together to form a stacked die. FIGS. 5-7 illustrate an example chip 500. In particular, FIG. 5 illustrates a side view of the chip 500; FIG. 6 illustrates a top view of the chip 500 shown in FIG. 5; and FIG. 7 illustrates a bottom view of the chip 500 shown in FIG. 5.

Referring to FIG. 5, the chip 500 may include a chip top portion 502, a chip bottom portion 504, a chip middle portion 506, a chip top protection ring 508, and a chip bottom protection ring 510. The chip middle portion 506 may be disposed between the chip top portion 502 and the chip bottom portion 504. The chip top protection ring 508 may be disposed proximate and/or may be coupled to the chip top portion 502. The chip bottom protection ring 510 may be disposed proximate and/or may be coupled to the chip bottom portion 504. The various couplings of components of the chip 500 may be accomplished in any desired way, such as, soldering, welding, etc.

The chip top portion 502, as shown in more detail in FIG. 6, may include a chip top working area 602, a chip top protection area 604, and the chip top protection ring 508. The chip top working area 602 may be enclosed by the chip protection area 604 and may be used for positioning and/or coupling of various electronic components associated with the chip 500. The chip protection area 604 may be further enclosed by the chip top protection ring 508.

The chip bottom portion 504, as shown in more detail in FIG. 7, may include a chip bottom working area 702 and the chip bottom protection ring 510. The chip bottom working area 702 may be enclosed by the chip bottom protection ring 510 and may be used for positioning and/or coupling of various electronic components associated with the chip 500.

The chip 500, as shown in FIGS. 5-7, may be used in various electronics applications, such as, for example, in the multi-point data transmission devices, systems, etc. Chip 500 may be used to protect against voltage transients that may be detrimental to operation of various electronic components.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by very fast rise times and very high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 50 volts in electrical cables. In a cloud-to-ground strike, the voltage transient generating effect is significantly greater.

Referring back to FIGS. 5-7, in some cases, TVS chips may be packaged using surface mounting (e.g., SMC) packaging, which provides for high power while having an overall small size. For example, SMC packaging may be used in printed circuit boards (PCBs) to protect various electronic components from ESD, electrical fast transients (EFT), lightning, and/or any other transients. SMC packaging allows for surface mounting of electronic components as well as optimization of the space on the PCB (on which such components may be mounted). It may further be characterized by a small profile, improved clamping capability, as well as other enhanced features.

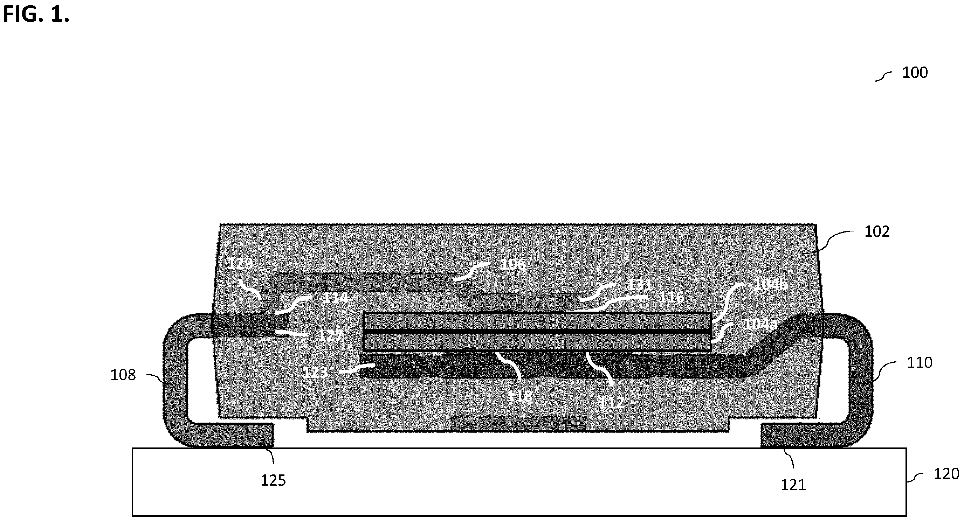

FIG. 1 illustrates an exemplary semiconductor device structure 100, according to some implementations of the current subject matter. The structure 100 may include a housing or an encapsulation 102, a first semiconductor chip 104a, a second semiconductor chip 104b coupled to and/or stacked on top on the first semiconductor chip 104b, a clip 106, a first lead 108, a second lead 110, and a chip support or mounting (terms used interchangeably herein) pad 112 (which may be disposed on the second lead 110). The semiconductor chips 104a, 104b may be similar to the chip 500 shown and discussed in connection with FIGS. 5-7.

The housing 102 may be configured to house and/or encapsulate the chips 104a and 104b, the clip 106, and at least portions of the first lead 108 and the second lead 110, including the chip support pad 112. The first lead 108 and the second lead 110 may be configured to extend from the housing 102 for conductively coupling to other electronic components and/or printed circuit board(s). The housing 102 may be configured to be manufactured from an epoxy compound, a plastic, and/or any other suitable material.

The first lead 108 may include a first end 125 and a second end 127. The first end 125 of the first lead 108 may be coupled to a substrate and/or printed circuit board (PCB) 120 and/or any other electronic component using any known mechanisms (e.g., solder, welding, etc.). The second end 127 may be coupled to the clip 106 using a conductive solder 114. In particular, the second end 127 of the first lead 108 may be coupled a first end 129 of the clip 106. While FIG. 1 illustrates the first lead 108 as having a curved shape, it can be understood, that the first lead 108 may have any desired shape and/or its shape may be changed to accommodate various circuit structures and/or positionings.

The second lead 110 may include a first end 121 and a second end 123. The first end 121 of the second lead 110 may be coupled to the PCB 120 and/or any other electronic component using any known mechanisms (e.g., solder, welding, etc.). The second lead 110 may also include the chip support pad 112 that may be disposed (e.g., soldered, welded, molded, etc.) proximate to the second end 123 of the second lead 110. The chip support pad 112 may also be coupled to the first chip 104a using a conductive solder 118. Similarly, while FIG. 1 illustrates the second lead 110 as having a curved shape, it can be understood, that the second lead 110 may have any desired shape and/or its shape may be changed to accommodate various circuit structures and/or positionings. The second semiconductor chip 104b may be configured to be coupled on top of the first semiconductor chip 104a. The top portion of the second semiconductor chip 104a may be coupled to end 131 of the clip 106 using conductive solder 116.

In some implementations, the first and second leads 108, 110 may be manufactured from a conductive material, such as, for example, but not limited to, copper, copper alloy, silver, metallic alloys, etc., and/or any combinations thereof. The leads 108, 110 may be further configured to provide electrical connections between the chips 104a and 104b and a circuit to which the structure 100 may be connected (e.g., PCB 120).

The first lead 108 may be configured as a cathode and the second lead 110 may be configured as an anode, such as, for example, in a case of unidirectional TVS products. As can be understood, any other implementations of the leads 108 and 110 are possible.

As stated above, the second semiconductor chip 104b (similar to the chip 500 shown in FIGS. 5-7) may be coupled to the clip 106. The coupling of the second chip 104b and the clip 106 may occur within the housing 102. Moreover, second chip 104b's top working panel (e.g., working area 602 shown in FIG. 6) may be configured to be conductively coupled to a second end 131 of the clip 106 using the conductive solder 116. Further, second chip 104b's bottom working panel (e.g., working area 502 shown in FIG. 5) may be configured to be conductively coupled to top working area (e.g., working area 602 shown in FIG. 6) of the first chop 104a, whoe bottom working panel is coupled to the chip support pad 112 using conductive solder 118.

In some implementations, the clip 106 may be manufactured from a conductive material, such as, for example, but not limited to, copper, copper alloy, silver, metallic alloys, etc., and/or any combinations thereof. The clip 106 may be configured to provide an electrical path between the substrate 120, the chips 104a and 104b, and the first and second leads 108, 110. The clip 106 may be configured to have a curved shape, a portion of which may be configured to extend away from the first lead 108 as well as the second chip 104b.

The clip 106 may be configured to absorb more solder during an assembly process of the structure 100 and may further enhance reliability of the structure 100 during operation. Moreover, clip 106 may include various structural features (e.g., heat dissipation panel and clip support process bars, as discussed in further detail below) that may be configured to improve and speed up heat dissipation during operation.

In some implementations, one or more of the sides of the semiconductor chips 104a and 104b may be configured to be coupled to one or more masks that may be prevent dislocation and/or disconnection of leads and/or clip (e.g., the first chip 104a from the clip 106, the second chip 104b from the clip 110, etc.; the first chip 104a from the second chip 104b and vice versa, etc.). The masks may be configured to prevent peeling of silicon from the chips. They may also constrain flow of solder compounds that are used to couple the semiconductor chips 104a and 104b and various components of the semiconductor device 100, e.g., clip 106, lead 110, etc.

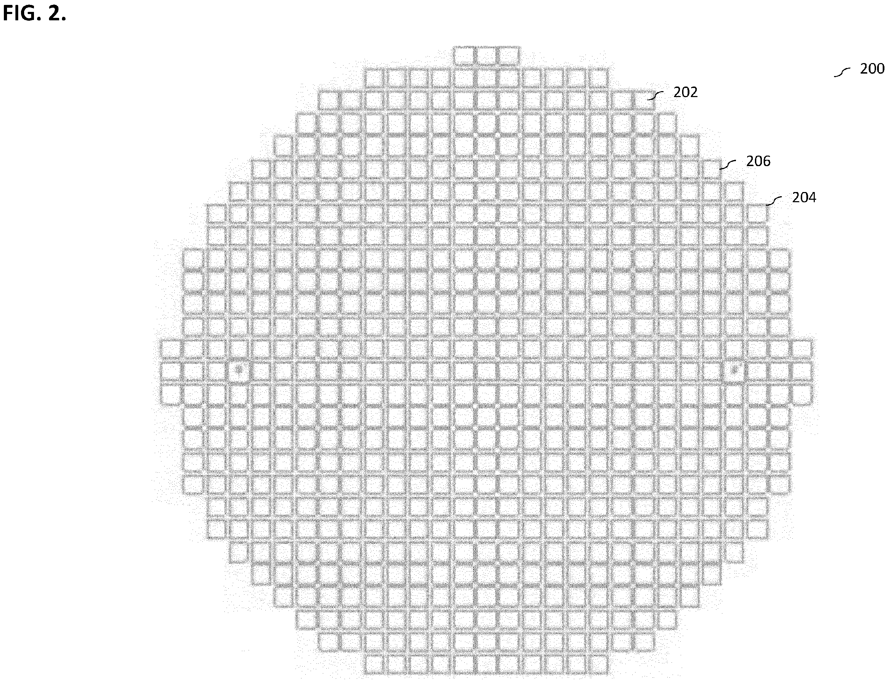

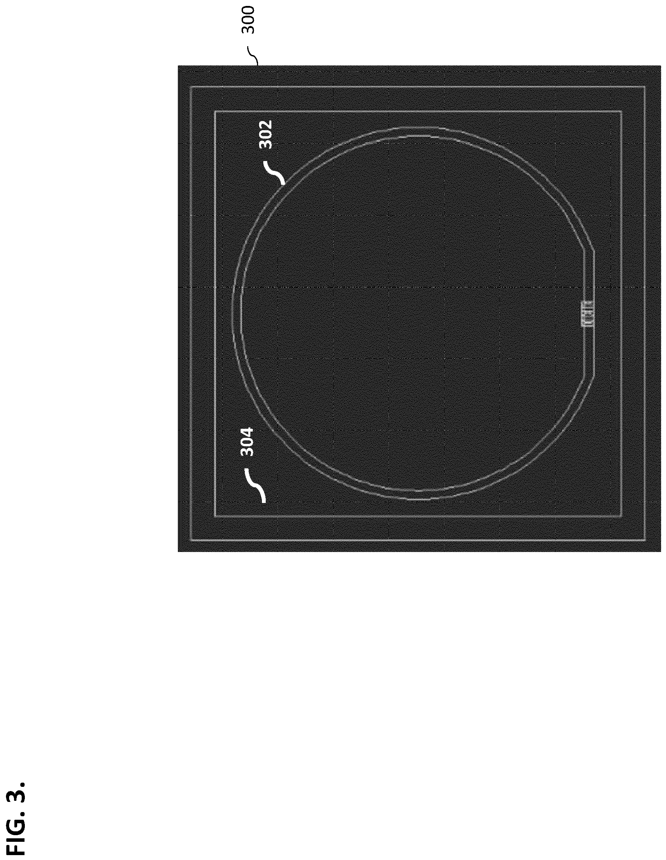

FIG. 2 illustrates a top view of the mask 200, according to some implementations of the current subject matter. The mask 200 may be configured to include a plurality of cells 202 that may be arranged as lattice 204. The cells 202 in the lattice 204 may be configured to be arranged in a circular fashion. For example, such arrangement may be used to fit within a ring structure (as shown in FIGS. 3-4) that may be configured to retain the lattice 204.

As shown in FIG. 2, each cell 202 in the lattice 204 may be configured to have a rectangular and/or square shape. As can be understood, any other shape of the cells 202 is possible. Further, all cells 202 in the lattice 204 may be configured to have a uniform shape and/or size. Alternatively, or in addition, the cells 202 may have different shapes and/or sizes. Moreover, cells 202 having different sizes may be distributed across the lattice 204 in any desired and/or predetermined way. By way of a non-limiting example, larger size cells 202 may be positioned toward the center of the lattice 204 (e.g., symmetrically about the center of the lattice 204) and smaller size cells 202 may be positioned toward edges of the lattice 204 (e.g., symmetrically about the center of the lattice 204). Arrangements of the cells 202 in the lattice 204 may be formed for specific applications.

Each cell 202 may be configured to be characterized by borders 206. Each border 206 may be configured to have a predetermined height and/or thickness. The heights and/or thicknesses of borders 206 may be configured to be uniform throughout the lattice 204. Alternatively, or in addition, the heights and/or thicknesses of borders 206 may be configured to from one cell 202 to another cell 202 in the lattice 204. By having predetermined heights/thicknesses, the borders 206 may be configured to retain binding compounds (e.g., solder) applied between the semiconductor chips 104a and/or 104b and various connecting components (e.g., clips, leads, etc.) and inhibit migration of such binding compounds away from the intended binding locations of the chips 104a, 104b and/or the connecting components, thereby, preventing chip damage through silicon pealing.

While FIG. 2 illustrates a circular arrangement of cells 202 in the lattice 204 and square-shaped cells 202, it should be understood that any other arrangement of cells 202 the lattice 204 is possible. Moreover, any other shapes and/or sizes of cells 202 are possible. Further, any desired arrangement of heights and/or thicknesses of the cells 202 may likewise be selected (e.g., in accordance with a particular application.

FIG. 3 illustrates an exemplary ring structure 302, according to some implementations of the current subject matter. The ring structure 302 may be positioned on a back side 304 of a semiconductor chip 300. The chip 300 may be similar to the semiconductor chip 104a and/or 104b shown in FIG. 1 and/or chip 500 shown in FIG. 5. The back side 304 may be similar to the chip rear working panel 702 of the chip 500 shown in FIG. 7.

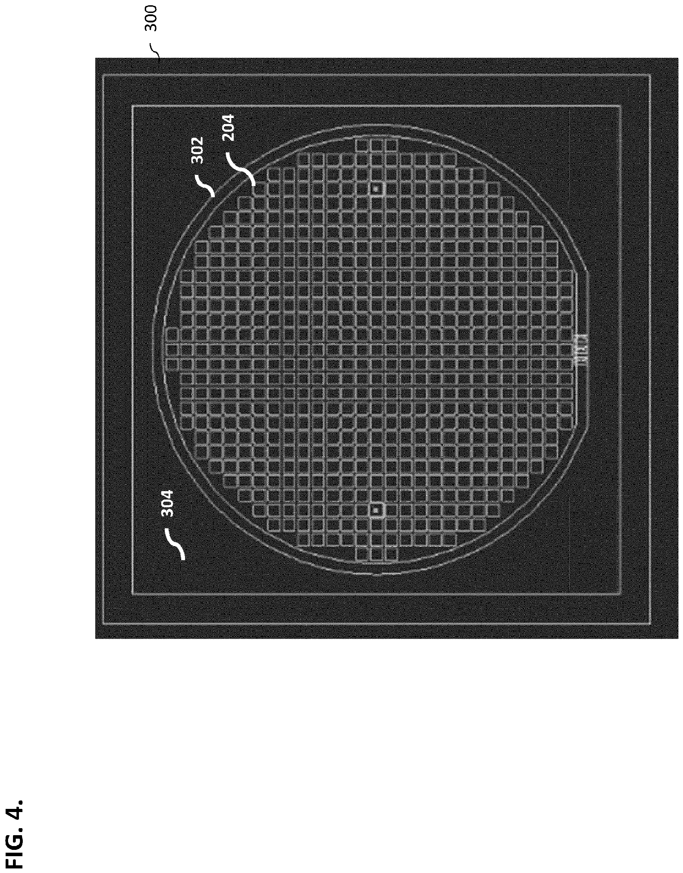

The ring structure 302 may be configured to have a predetermined radius and may be sized to closely fit within the back side 304 of the chip 300. For example, the size of the ring structure 302 may be configured to accommodate positioning of the lattice 204 (shown in FIG. 2) within its borders, as illustrated in FIG. 4.

The ring structure 302 may be configured to be coupled to the back side 304 of the semiconductor chip 300 using any desired means, e.g., soldering, dry etching, wet etching, and/or any other processes. The ring structure 302 and/or the lattice 204 may be configured to be manufactured from any desired materials, such as, for example, metal, metal oxide, composite materials, polymer materials, silicon and/or silicon compounds, etc.

Once the ring structure 302 containing the lattice 204 is coupled to the back side of the semiconductor chip, solder and/or any other binding components may be applied to secure the semiconductor chip to other components within the semiconductor device (e.g., chip 104a being coupled to chip 104b, chip 104b being coupled to the lead 110, etc.). Use of the lattice 204 retains solder inside the cells 202 and use of the ring structure 302 prevents outflow of solder external to the border of the ring structure 302, thereby protecting the semiconductor chips from silicon pealing and/or other damage. Moreover, the ring structure 302 including the lattice 204 may be configured to prevent movement of the semiconductor chips by retaining them in a single location.

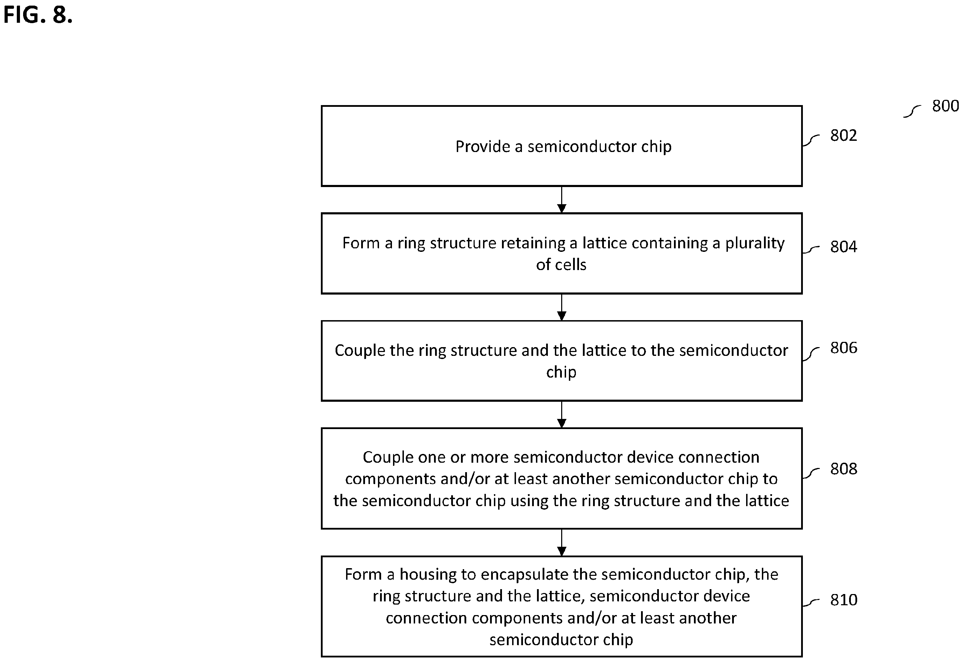

FIG. 8 illustrates an exemplary process 800 for manufacturing a semiconductor device having a semiconductor chip retaining structure, according to some implementations of the current subject matter. The process 800 may be used for manufacturing and/or assembling the structure 100 shown and discussed above in connection with FIGS. 1-4. The process 800 may be used for manufacturing/assembling any type of semiconductor devices

At 802, a semiconductor chip may be provided. For example, the semiconductor chip may be a power semiconductor chip, e.g., rated for 5000 W and/or greater, and/or any other type of chip. The semiconductor chip may have any desired shape, e.g., a rectangular, non-square shape, square shape, etc. An example of such chip is chip 104a, chip 104b, as shown in FIG. 1.

At 804, a ring structure retaining a lattice containing a plurality of cells may be formed. For example, the ring structure may be ring structure 302, as shown in FIG. 3, that may be configured to retaining a lattice 204 (shown in FIG. 2). The lattice 204 may be configured to include on or more cells 202. The cells may be configured to be arranged in a predetermined way, as illustrated in FIG. 2.

At 806, the ring structure and the lattice may be coupled to the semiconductor chip. In particular, the ring structure and the lattice may be coupled to the back side of the semiconductor chip, as shown in FIGS. 3-4. As can be understood, the ring structure and the lattice may be coupled to any side of the semiconductor chip.

At 808, one or more semiconductor device connection components and/or at least another semiconductor chip may be coupled to semiconductor chip using the ring structure and the lattice. For example, the ring structure and the lattice may be used for coupling chips 104a and 104b as well as one or more leads and/or clip, as shown in FIG. 1.

At 810, a housing may be formed to encapsulate the semiconductor chip, the ring structure and the lattice, semiconductor device connection components and/or at least another semiconductor chip.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth and spirit of the present disclosure as described herein.

## Claims

1. An apparatus, comprising:
a semiconductor chip;
a ring structure configured to retain a lattice having a plurality of cells, the ring structure and the lattice being coupled to the semiconductor chip;
one or more semiconductor device connection components being coupled to the semiconductor chip using one or more binding components disposed within the ring structure and the lattice.

2. The apparatus according to claim 1, wherein the ring structure and the lattice are configured to be coupled to a bottom side of the semiconductor chip.

3. The apparatus according to claim 1 or 2, wherein another semiconductor chip is coupled to the bottom side of the semiconductor chip, wherein the ring structure and the lattice are configured to be disposed between the semiconductor chip and the another semiconductor chip, thereby preventing shifting of at least one of the semiconductor chip and the another semiconductor chip, preferably wherein the another semiconductor chip is coupled to another ring structure configured to retain another lattice having a plurality of another cells.

4. The apparatus according to any of the preceding claims, wherein each cell in the plurality of cells has at least one of: a predetermined size, a predetermined shape, a predetermined height, and any combination thereof.

5. The apparatus according to claim 4, wherein all cells in the plurality of cells have same at least one of: size, shape, height, and any combination thereof, or
wherein at least one cell in the plurality of cells has a different size, shape, and/or height than at least another cell in the plurality of cells.

6. The apparatus according to any of the preceding claims, wherein the ring structure is configured to be coupled to the lattice.

7. The apparatus according to any of the preceding claims, wherein the plurality of cells is configured to be evenly distributed within the ring structure or
wherein the plurality of cells is configured to be randomly distributed within the ring structure.

8. The apparatus according to any of the preceding claims, wherein the one or more binding components are configured to be retained by one or more cells in the plurality of cells.

9. The apparatus according to any of the preceding claims, wherein the ring structure is configured to prevent spilling of the one or more binding components outside of the ring structure and the lattice.

10. The apparatus according to any of the preceding claims, wherein the one or more binding components include solder.

11. The apparatus according to any of the preceding claims, wherein the one or more semiconductor device connection components include a lead frame configured to be coupled to a bottom side of the semiconductor chip using the one or more binding components, wherein the ring structure and the lattice are configured to be positioned between the lead frame and the semiconductor chip, preferably wherein the one or more semiconductor device connection components include a clip fully encapsulated by the housing, wherein another lead frame is configured to be coupled to the clip, more preferably wherein the clip is configured to be coupled to the semiconductor chip.

12. The apparatus according to claim 11, where the lead frame includes a lead frame terminal end and the another lead frame includes another lead frame terminal end, preferably
wherein the lead frame terminal end and the another lead terminal frame end are configured to be coupled to at least one of the following: a substrate, a printed circuit board, and any combination thereof.

13. The apparatus according to any of the preceding claims, further comprising a transient voltage suppression device.

14. The apparatus according to any of the preceding claims, further comprising a housing, preferably wherein the housing is manufactured from at least one of the following: an epoxy compound, a plastic, and any combination thereof.

15. A method, comprising:
providing a semiconductor chip;
forming a ring structure configured to retain a lattice having a plurality of cells;
coupling the ring structure and the lattice to the semiconductor chip;
coupling one or more semiconductor device connection components to the semiconductor chip using one or more binding components disposed within the ring structure and the lattice: and
preferably forming a housing configured to encapsulate the semiconductor chip, the ring structure and the lattice, and the one or more semiconductor device connection components.
